# EUROPÄISCHE PATENTANMELDUNG

(11) **EP 2 273 566 A1**
(43) Veröffentlichungstag der Anmeldung: **12.01.2011**
(21) Anmeldenummer: 09008537.4
(22) Anmeldetag: 30.06.2009
(51) Int. Cl.: H01L 31/18

(54) **Vorrichtung und Verfahren zum Lagefixieren eines Lötverbinders auf einer Solarzelle**

(71) Anmelder: Feintool Intellectual Property AG, 3250 Lyss (CH)
(72) Erfinder: Nowak, Andreas, Dipl.-Ing., 16341 Panketal (DE)
(74) Vertreter: Hannig, Wolf-Dieter

(57) **Zusammenfassung**

Die Erfindung betrifft eine Vorrichtung und ein Verfahren zum Lagefixieren eines Verbinders aus verzinntem Lötband auf einer Solarzelle.
Der Greif- und Ablageeinrichtung (6) ist eine im Takt arbeitende Heftstation (7) zum Heften des Verbinders (3.1...3.n) an die Solarzelle (2.1...2.n) zugeordnet, die zwischen der Greif- und Ablageeinrichtung (4,6) und der Lötstation angeordnet ist.

## Beschreibung

Die Erfindung betrifft eine Vorrichtung zum Lagefixieren eines Verbinders (Ribbon) aus verzinntem Lötband auf einer Solarzelle beim Transport in einer Fertigungsanlage zur Herstellung von Solarzellenstrings, mit einem von einem Antrieb angetriebenen Transportband zum Bewegen von Verbinder und Solarzelle zu einer Bearbeitungsstation und einer Greif- und Ablageeinrichtung zum taktweisen Greifen und Ablegen von Verbinder und Solarzelle in einer verbindungsgerechten Anordnung auf dem Transportband.

Die Erfindung betrifft ferner ein Verfahren zum Lagefixieren eines Verbinders (Ribbon) aus verzinntem Lötband auf einer Solarzelle beim Transport in einer Fertigungsanlage zur Herstellung von Solarzellenstrings.

### Stand der Technik

Aus der DE 102 97 644 T5 ist eine Solarzellenaufreihungsmaschine zur Herstellung von Solarzellenstrings bekannt, bei der die zu verbindenden Solarzellen auf einer mit Schritt-Motoren durch die Maschine geführten Platte abgelegt werden. Die Solarzellen werden mittels Greifelemente in ihrer Position zueinander gehalten, die zur Verbindung der Solarzellen benötigten Verbinder (Ribbon) aufgelegt und durch Klemmelemente festgeklemmt. Anschließend erfolgt das Verlöten der Ribbons an den Solarzellen in einer Lötstation.
Von Nachteil ist, dass Verbinder und Solarzelle während ihres gesamten Transportprozesses bis zur Lötstation im geklemmten Zustand gehalten werden müssen. Neben dem erheblichen maschinentechnischen Aufwand an Baugruppen und Bauteilen, begrenzt dies die Taktzahl, d.h. den Durchsatz der Maschine. Außerdem entstehen bei diesem bekannten Stand der Technik beträchtliche Probleme bei der Umrüstung der Maschine auf unterschiedliche Solarzellengrößen bzw. Solarzellenstrings. Die Maschine ist wenig flexibel in Bezug auf die Anzahl der Solarzellen in den Solarzellenstrings. Ebenso entstehen Probleme am Übergang von einer Bearbeitungsstufe zur anderen.

Andere bekannte Lösungen, wie beispielsweise in der DE 10 2006 007 447 A1 vorgeschlagen, setzen Streifen-Niederhalteelemente ein, die die auf die Solarzelle abgelegten Verbinder andrücken und fixieren. Das entsprechende Niederhaltelement wird dann zusammen mit der Solarzelle weitertransportiert und nach Durchlaufen der Lötstation wieder abgehoben.
Auch bei dieser bekannten Lösung wird dem Nachteil einer ständigen Niederhaltefunktion durch Fixieren und Klemmen von Ribbon und Solarzelle beim Transport bis zur Lötstation nicht abgeholfen. Die empfindliche Solarzelle bleibt während ihres gesamten Transports einer ständigen Krafteinwirkung durch die Niederhaltelemente ausgesetzt, wodurch sich entsprechende nachteilige mechanische Belastungen für die Solarzellen nicht ausschließen lassen. Der maschinentechnische Aufwand für ein solches Niederhaltesystem ist entsprechend hoch. Außerdem muss das Niederhaltesystem durch die thermischen Belastungen in der Lötstation besondere Materialeigenschaften, beispielsweise Temperaturbeständigkeit, aufweisen.

### Aufgabenstellung

Bei diesem Stand der Technik liegt der Erfindung die Aufgabe zugrunde, eine Vorrichtung und ein Verfahren zum Lagefixieren eines Verbinders an einer Solarzelle zu entwickeln, die bzw. das es ermöglicht, das ständige Niederhalten des Verbinders auf der Solarzelle beim Transport bis zur Verbindungsstation unter gleichzeitiger Verringerung des maschinentechnischen Aufwandes, der Erhöhung des Durchsatzes und der Qualität sowie Beibehaltung einer hohen Flexibilität in Wegfall zu bringen.

Diese Aufgabe wird durch eine Vorrichtung der eingangs genannten Gattung mit den Merkmalen des Anspruchs 1 und durch ein Verfahren mit den Merkmalen des Anspruches 13 gelöst.

Vorteilhafte Ausgestaltungen der erfindungsgemäßen Vorrichtung und des erfindungsgemäßen Verfahrens sind den Unteransprüchen entnehmbar

Die erfindungsgemäße Lösung geht von der Erkenntnis aus, die mechanische Beanspruchung der Solarzellen bei ihrer verbindungsgerechten Konfektionierung innerhalb ihres Transportweges bis zur Lötstation wesentlich herabzusetzen. Dies wird dadurch erreicht, dass der Greif- und Ablageeinrichtung eine im Takt arbeitende Heftstation zum Heften des Verbinders an die Solarzelle zugeordnet ist, die zwischen der Greif- und Ablageeinrichtung und der Lötstation angeordnet ist.

In einer bevorzugten Ausführungsform der erfindungsgemäßen Vorrichtung umfasst die Heftstation:
a eine Zustelleinheit zum vertikalen Zustellen eines Heftkopfes in Bezug auf den in einem losen Verbund mit der Solarzelle auf dem Transportband durch die Greifeinrichtung gehaltenen Verbinder,
b einen Heftkopf mit mindestens einem Heftstift zum Aufbringen einer Fixierkraft auf den Verbinder beim Aufsetzen des Heftkopfes auf den Verbund durch die Zustelleinheit, wobei für jeden Heftkopf ein vertikales Ausgleichsystem vorgesehen ist, das die Fixierkraft auf den Verbinder durch eine Federkraft aufbringt,
c eine in den Heftstift eingesetzte Heizpatrone zum Erzeugen der Hefttemperatur und eine am Heftstift aufgesetzte Heftspitze zum punktuellen Heften des Verbinders an der Solarzelle.
Dies ist mit dem außerordentlichen Vorteil verbunden, dass der Verbund von Verbinder und Solarzelle unmittelbar nach ihrer verbindungsgerechten Anordnung auf dem Transportband federnd fixiert und anschließend punktuell geheftet werden.
Ein Niederhalten des Verbinders auf der Solarzelle bei seinem Transport zur Lötstation entfällt völlig. Das Heften ist äußerst temperaturschonend und reicht aus, um ein Verrutschen der Verbinders auf der Solarzelle beim Transport zur Lötstation sicher zu verhindern.

Nach einer vorteilhaften Ausführungsform der erfindungsgemäßen Vorrichtung ist die Zustelleinheit zum Erzeugen einer schnellen Zustellbewegung des Heftkopfes mit einem Pneumatikzylinder ausgerüstet, der in einer Schräglage innerhalb der Zustelleinheit um sein der Zylinderstange abgewandtes Ende schwenkbar angeordnet ist, wobei die Zylinderstange des Pneumatikzylinders mit einem Arm eines Winkelhebels zur Verlangsamung am Ende der Zustellbewegung schwenkbar verbunden ist, dessen anderer Arm schwenkbar an einem Träger für den Heftkopf angelenkt ist und der Winkelhebel um eine zu seinen Armen etwa symmetrisch angeordnete Achse drehbar ist. Dies ermöglicht einen annähernd sinuiden Bewegungsablauf, d.h. die Zustellbewegung des Heftkopfes verläuft am Anfang der Bewegung schnell in Richtung des zu heftenden Verbinders und am Ende der Bewegung gebremst, so dass der Heftstift mit seiner Heftspitze schonend auf den Verbinder und damit auf Solarzelle aufsetzt. Bevorzugt ist dabei vorgesehen, dass der den Heftkopf tragende Träger in zueinander parallel angeordneten Führungen vertikal verschiebbar angeordnet ist, wodurch alle zum Heftkopf gehörenden Heftspitzen gleichmäßig abgesenkt werden können und gleichzeitig auf dem Verbinder aufsetzen. Natürlich gehört es auch zu der Erfindung, wenn anstelle eines pneumatischen Antriebs ein elektrischer Antrieb für die Zustellbewegung eingesetzt wird.

In weiterer bevorzugter Ausgestaltung der erfindungsgemäßen Vorrichtung weist der Heftkopf einen Träger auf, in dem mindestens ein Heftstift in einer Führungsbuchse linear geführt angeordnet ist. Jeder Heftstift ist in vorteilhafterweise mit einem Ausgleichsystem versehen, das eine in der Führungsbuchse eingesetzte Druckfeder umfasst, die sicherstellt, dass die Heftspitze zusätzlich auf den Verbinder bei ihrem Aufsetzen eine Druckkraft zum Fixieren ausübt.
Dieses Ausgleichsystem kann aber in einer weiteren besonders bevorzugten Ausgestaltung auch aus mindestens zwei vertikal übereinander am Träger des Heftkopfes befestigten Blattfedern gebildet sein, die sowohl die Zustellkraft auf den Verbinder und die Führung des Heftstiftes übernehmen.

Eine weitere bevorzugte Ausführungsform der erfindungsgemäßen Vorrichtung sieht vor, dass die Heftköpfe an der Zustelleinheit einzeln aufgehängt angeordnet sind und die Anzahl der Heftköpfe der Anzahl der Verbinder der Solarzelle entspricht.

Von besonderem Vorteil ist weiterhin, dass die Heftspitze als Verschleißteil ausgebildet ist, so dass ein einfacher Austausch der Heftspitzen vorgenommen werden kann, sobald die Heftspitzen abgenutzt sind. Dies erhöht die Wartungsfreundlichkeit erheblich, weil die Heftstifte in ihren Führungsbuchsen verbleiben können und der Austauschvorgang einfach und wenig zeitintensiv ist.

Nach einer weiteren Variante der erfindungsgemäßen Vorrichtung ist es günstig, die Heizpatrone mit einem Temperatursensor zu versehen, der es gestattet, die Temperatur beim Heften genau zu kontrollieren und einzuhalten.

Besonders vorteilhaft für ein schnelles Verbinden von der Zustellstelleinheit mit dem Heftkopf ist ein Schnellverschluß, der einen einfachen Wechsel des Heftkopfes ermöglicht.

Die Aufgabe der Erfindung wird des Weiteren auch durch ein Verfahren gelöst, das die Solarzelle und den Verbinder durch jeweils eine separate Greif- und Ablageeinrichtung in einen zueinander losen Verbund verbindungsgerecht auf einem Transportband nacheinander getaktet platziert und gehalten werden, der Verbinder anschließend in seiner Ablageposition durch Absenken einer von einer Zustelleinheit gehaltenen, unter einer Federkraft stehenden Heftspitze auf der Solarzelle fixiert und mittels Löten aneinander geheftet werden, wobei die für den Verbinder zuständige Greif- und Ablageeinrichtung die zuvor fixierte Ablageposition freigibt, sobald das Heften beginnt oder abgeschlossen ist und erneut einen weiteren Verbinder für die nächstfolgende Solarzelle aufnimmt, diesen positioniert und an der Solarzelle fixiert.

Eine weitere vorteilhafte Ausführungsform des erfindungsgemäßen Verfahrens sieht vor, dass mehrere Lötverbinder auf der Solarzelle im Takt gleichzeitig geheftet werden, wobei für jeden Verbinder eine separate Heftspitze zum Heften verwendet wird.

Weitere Vorteile und Einzelheiten der Erfindung ergeben sich aus der nachfolgenden Beschreibung unter Bezugnahme auf die beigefügten Zeichnungen.

### Ausführungsbeispiel

Die Erfindung soll nachstehend an einem Ausführungsbeispiel näher erläutert werden.

### Es zeigt

Fig. 1 eine Seitenansicht eines verbindungsgerechten losen Verbundes aus Verbinder und Solarzellen auf einem Transportband,

Fig. 2 eine perspektivische Darstellung der erfindungsgemäßen Vorrichtung mit den Greif- und Ablageeinrichtungen für Verbinder und Solarzelle,

Fig. 3 eine perspektivische Darstellung der Heftstation,

Fig. 4 eine perspektivische Darstellung der Zustelleinheit der Heftstation,

Fig. 5 einen Schnitt durch den Heftkopf in perspektivische Darstellung und

Fig. 6 eine schematische Darstellung einer Variante des Ausgleichssystems für den Heftstift.

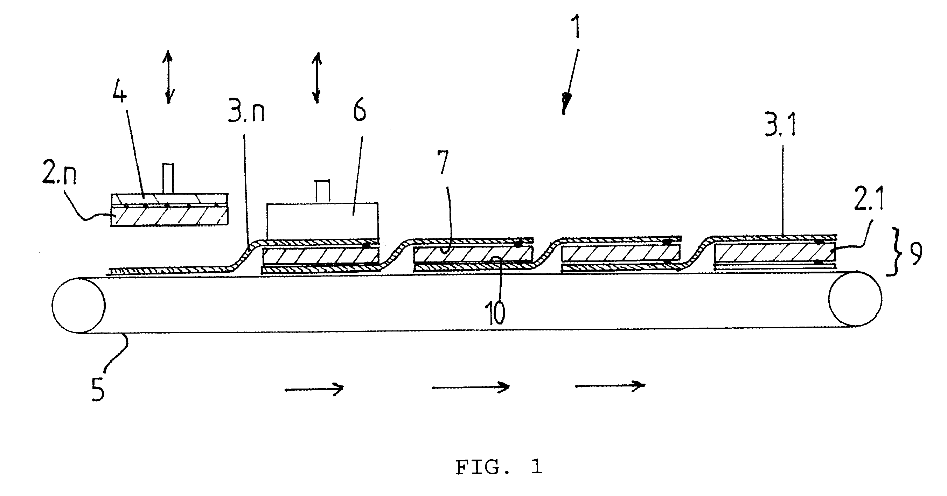

Die Fig. 1 zeigt einen Solarzellenstring 1, der sich aus mehreren aneinandergereihten Solarzellen 2.1...2.n zusammensetzt, die durch Lötverbinder 3.1,...3.n elektrisch verbunden werden sollen. Eine erste Solarzelle 2.1 wird durch eine Greif- und Ablageeinrichtung 4 auf ein beispielsweise taktweise bewegtes Transportband 5 abgelegt. Eine weitere Greif- und Ablageeinrichtung 6 legt auf die Oberseite 7 der ersten Solarzelle 2.1 einen Verbinder 3.1 ab und fixiert diesen solange auf der Solarzelle 2.1 bis eine später noch näher zu beschreibende Heftstation 8 den losen Verbund 9 aus Verbinder 3.1 und Solarzelle 2.1 zum punktuellen Heften mittels Löten im Takt mit der Greif- und Ablageeinrichtung 6 übernommen hat. Die Greif- und Ablageeinrichtung 4 legt eine zweite Solarzelle 2.2 auf das im Takt weitergefahrene Transportband 5 so ab, dass die Unterseite 10 der zweiten Solarzelle 2.2 auf den bereits abgelegten Verbinder 3.1 zu liegen kommt. Die Greif- und Ablageeinrichtung 6 platziert den nächsten Verbinder 3.2 auf der zweiten Solarzelle 2.2, fixiert diesen und übergibt den losen Verbund 9 aus Verbinder 3.2 und Solarzelle 2.2 an die Heftstation 8 zum Heften des Verbinders 3.1 an der Oberseite 4 der Solarzelle 2.2.
Das Aneinanderreihen der Solarzellen 2.1,...2.n und das Heften setzt sich solange fort bis die gewünschte Länge des Solarzellenstrings 1 erreicht ist.
Das Fixieren durch die Greif- und Anlageeinrichtung 6 und das Heften durch die Heftstation 8 kann auch so ablaufen, dass die Greif- und Ablageeinrichtung 6 den Verbund 9 erst dann freigibt, wenn der Heftvorgang zwischen dem Verbinder und der Solarzelle abgeschlossen ist.

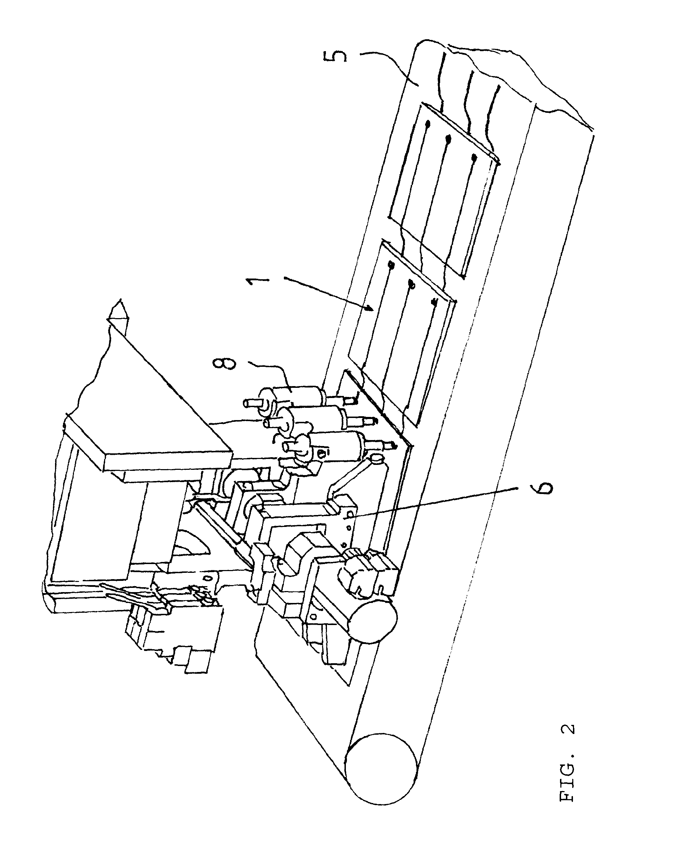

Die Fig. 2 zeigt die erfindungsgemäße Vorrichtung in perspektivischer Funktionsdarstellung, bei der sich auf dem Transportband 5 eine Reihe von aneinander gehefteten Solarzellen 2.1....2.3 befinden, mit einer nicht weiter dargestellten Zuführeinrichtung für die Solarzellen 2.1...2.n, der Greif- und Ablageeinrichtung 4 (siehe auch Fig.1) für die Solarzelle 2.1...2.2, der Greif- und Ablageeinrichtung 6 für die Verbinder 3.1...3.n und die Heftstation 8.

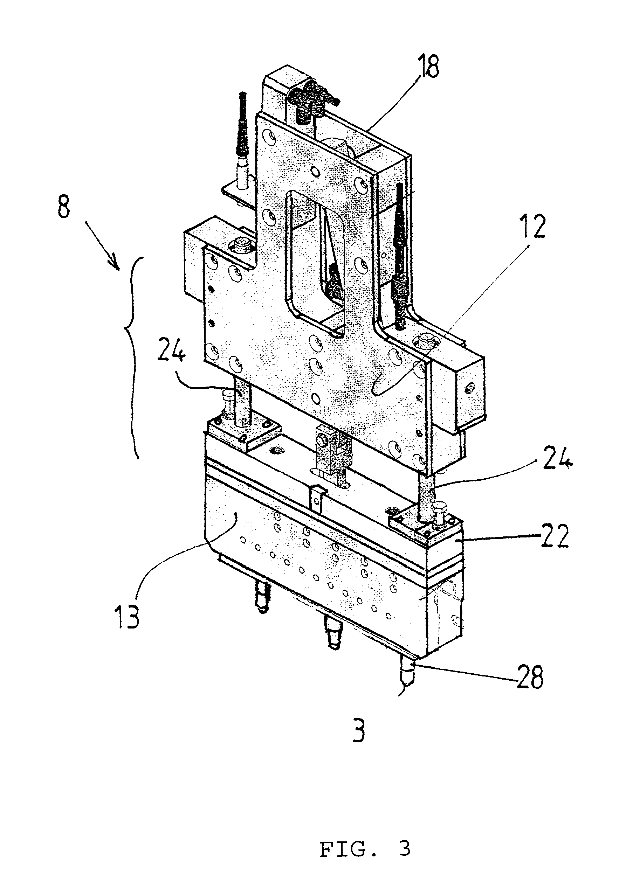

Die in Fig. 3 gezeigte Heftstation 8 setzt sich aus einer Zustelleinheit 12 und einem in Bezug auf den Verbund 9 vertikal zustellbaren Heftkopf 13 zusammen, die miteinander durch einen Schnellverschluß 14 verbunden sind, so dass ein einfaches und schnelles Wechseln des Heftkopfes 13 gewährleistet ist.

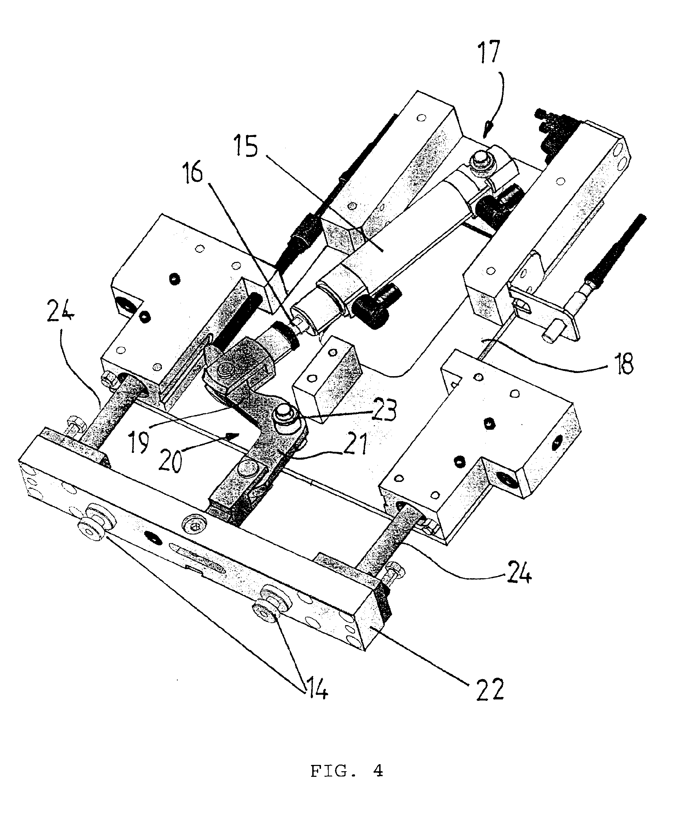

Die Zustelleinheit 12 ist zum Erzeugen einer schnellen Zustellbewegung des Heftkopfes 13 in Bezug auf den losen Verbund 9 aus Verbinder 3.1,...3.n und Solarzelle 2.1,...2.n ausgelegt. Die schnelle Zustellbewegung wird durch einen Pneumatikzylinder 15 (siehe Fig. 4) erreicht, der in einer Schräglage innerhalb der Zustelleinheit 12 um sein der Zylinderstange 16 abgewandtes Ende 17 schwenkbar an einer Gehäusewand 18 der Zustelleinheit 12 festgelegt ist. Die Zylinderstange 16 des Pneumatikzylinders 15 ist anderenends mit einem Arm 19 eines Winkelhebels 20 schwenkbar verbunden. Der andere Arm 21 des Winkelhebels 20 ist an einem Träger 22 für den Heftkopf 13 schwenkbar befestigt, wobei der Winkelhebel 20 selbst um eine zu den Armen 19 und 21 etwa symmetrisch angeordnete Achse 23 drehbar ist. Die Achse 23 liegt in Flucht des schwenkbaren Endes 17 des Pneumatikzylinders 15. Der Winkelhebel 20 ermöglicht es, die schnelle Zustellbewegung in Bezug auf den losen Verbund 9 aus Verbinder 3.1...3.n und Solarzelle 2.1...2 .n deutlich zu verlangsamen, um ein sanftes Aufsetzen des Heftkopfes 13 auf die Solarzellen 2.1...2.n sicherzustellen.
Der Träger 22, an dem der Heftkopf 13 mit dem Schnellverschluss festliegt, ist in zwei im Gehäuse der Zustelleinheit 12 zueinander parallel gelegene Führungen 24 vertikal in Richtung des Verbundes 9 aus Verbinder 3.1...3.n und Solarzelle 2.1...2.n verschiebbar angeordnet, wodurch der Heftkopf 13 über seine gesamte Länge gegenüber dem Verbund 9 eine horizontale Lage bei der Zustellbewegung einnimmt.

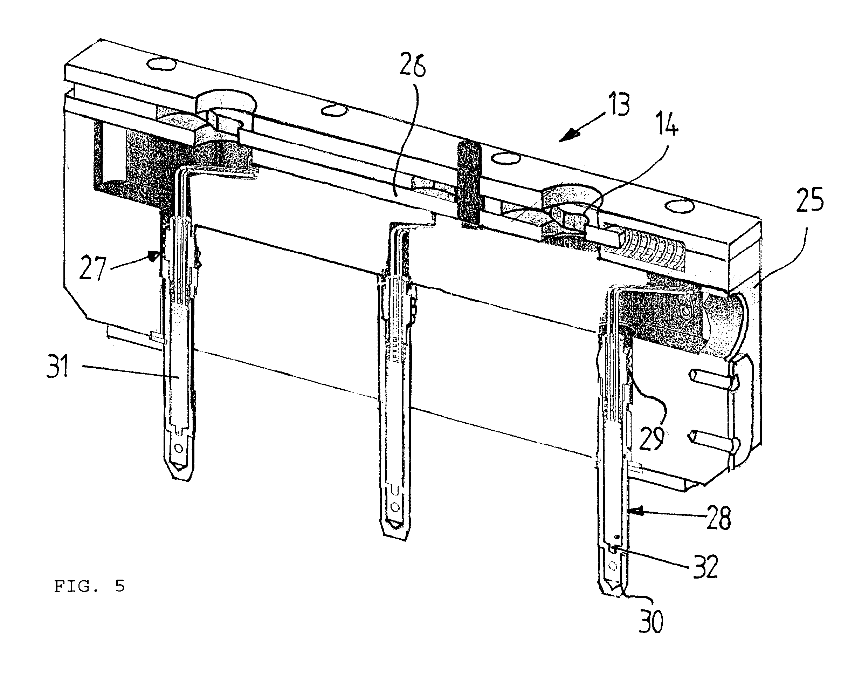

Die Fig. 5 zeigt einen Schnitt des Heftkopfes 13. Der Heftkopf 13 besitzt ein quaderförmig ausgebildetes Gehäuse 25, das an einem Träger 26 befestigt ist, welcher über den Schnellverschluss 14 mit dem Träger 22 der Zustelleinheit 12 koppelbar ist.
Im Gehäuse 25 sind vertikal angeordnete Führungsbuchsen 27 vorgesehen, in denen Heftstifte 28 eingesetzt sind, die in der Führungsbuchse 27 gegen ein Ausgleichsystem in Form einer Druckfeder 29 verschiebbar angeordnet sind, um eine entsprechende Andruckkraft beim Aufsetzen der mit Heftspitzen 30 versehenen Heftstifte 28 auf den Verbund 9 aus Verbinder 3.1,...3.n und Solarzelle 2.1,...2.n zu erzeugen.
Jeder Heftstift 28 besitzt eine eigene Heizpatrone 31 zum Erzeugen der für das Heften erforderlichen Temperatur, die von einem dazugehörigen Temperatursensor 32 überwacht wird. Die Heftspitze 30 ist als Verschleißteil ausgebildet und auf den Heftstift 28 austauschbar aufgesetzt, so dass die Heftspitze 30 ohne Ausbau des Heftstiftes 28 problemlos gewechselt werden kann.

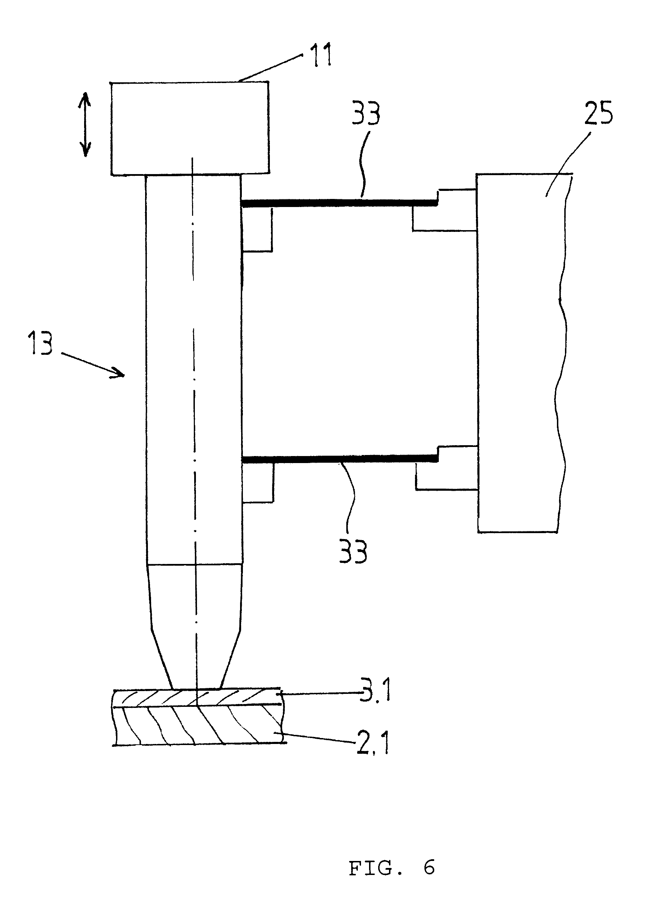

Das Ausgleichsystem zum Aufbringen einer entsprechenden Andruckkraft auf den Verbund 9 aus Verbinder 3.1...3.n und Solarzelle 2.1...2.n kann, wie Fig. 6 zeigt, auch aus mindestens zwei vertikal übereinander angeordneten Blattfedern 33 bestehen, die am Gehäuse 25 des Heftkopfes 13 befestigt sind, wodurch ein Parallelogramm zwischen Gehäuse 25, Heftstift 28 und den Blattfedern 33 ausgebildet wird, das sicherstellt, dass sich die Heftspitze 30 bei ihrer Auslenkung parallel zum Gehäuse 25 bewegt. Die Blattfedern 33 übernehmen dann sowohl die Funktion der Zustellkraft als auch die Führungsfunktion. Der Heftkopf 13 wird von einer entsprechend ausgelegten Zustelleinheit 11 vertikal zugestellt.
Dies ermöglicht, eine Gleitreibung als Störgröße auszuschließen.

An der Zustelleinheit 12 sind die Heftköpfe 13 jeweils einzeln hängend angekoppelt. Die Anzahl der Heftköpfe 13 richtet sich dabei nach der Anzahl der Verbinder 3.1,...3.n, die mit einer Solarzelle geheftet werden sollen. Mit anderen Worten, sind zur Verbindung der Solarzellen beispielsweise drei parallel zueinander angeordnete Verbinder erforderlich, sind jeweils drei Heftköpfe 13 im Abstand der Verbinder vorzusehen (siehe auch Fig. 2).

Das erfindungsgemäße Verfahren läuft wie folgt ab. Die Solarzelle 2.1...2.n und der Verbinder 3.1...3.n werden jeweils durch separate Greif- und Ablageeinrichtungen 4 und 6 in einen zueinander losen Verbund 9 verbindungsgerecht auf dem Transportband 5 nacheinander getaktet platziert und gehalten. Der Verbinder 3.1...3.n wird anschließend in seiner Ablageposition durch Absenken einer von der Zustelleinheit 12 gehaltenen, unter einer Federkraft stehenden Heftspitze 30 auf der Solarzelle fixiert. Verbinder 3.1...3.n und die Solarzelle 2.1,2.n werden sodann oberseitig durch Löten aneinander geheftet.
Die für den Verbinder zuständige Greif- und Ablageeinrichtung 6 gibt die zuvor fixierte Ablageposition des Verbundes aus Verbinder und Solarzelle im Takt frei, sobald das Heften beginnt oder abgeschlossen ist. Die Greif- und Ablageeinrichtung 6 fährt zurück, nimmt einen weiteren Verbinder von der Zuführeinheit für die nächstfolgende Solarzelle auf, positioniert und fixiert denselben wiederum solange bis die Heftstation mit dem Heften beginnt oder das Heften durchgeführt ist.

**Bezugszeichenliste**

| | |
|---|---|
| Solarzellenstring | 1 |
| Solarzelle | 2.1...2.n |
| Verbinder | 3.1...3.n |
| Greif- und Ablageeinrichtung für 2.1...2.n | 4 |
| Transportband | 5 |
| Greif- und Ablageeinrichtung für 3.1...3.n | 6 |
| Oberseite der Solarzelle | 7 |
| Heftstation | 8 |
| Verbund aus Solarzelle und Verbinder | 9 |
| Unterseite der Solarzelle | 10 |
| Zustelleinheit | 11 |
| Zustelleinheit | 12 |
| Heftkopf | 13 |
| Schnellverschluß | 14 |
| Pneumatikzylinder | 15 |
| Zylinderstange | 16 |
| Ende von 15 | 17 |
| Gehäusewand von 12 | 18 |
| Arm von 20 | 19, 21 |
| Winkelhebel | 20 |
| Träger von 12 | 22 |
| Achse | 23 |
| Führungen | 24 |
| Gehäuse von 13 | 25 |
| Träger von 13 | 26 |
| Führungsbuchsen | 27 |
| Heftstifte | 28 |
| Druckfeder | 29 |
| Heftspitze | 30 |
| Heizpatrone | 31 |
| Temperatursensor | 32 |
| Blattfedern | 33 |

## Patentansprüche

1. Vorrichtung zum Lagefixieren eines Verbinders (Ribbon) aus verzinntem Lötband auf einer Solarzelle beim Transport in einer Fertigungsanlage zur Herstellung von Solarzellenstrings, mit einem von einem Antrieb angetriebenen Transportband (5) zum Bewegen von Verbinder (3.1...3.n) und Solarzelle (2.1...2.n) zu einer Lötstation und einer Greif- und Ablageeinrichtung (4,6) zum taktweisen Greifen und Ablegen von Verbinder und Solarzelle in einer verbindungsgerechten Anordnung auf dem Transportband (5), **dadurch gekennzeichnet, dass** der Greif- und Ablageeinrichtung (6) eine im Takt arbeitende Heftstation (8) zum Heften des Verbinders (3.1...3.n) an die Solarzelle (2.1...2.n) zugeordnet ist, die zwischen der Greif- und Ablageeinrichtung (4,6) und der Lötstation angeordnet ist.

2. Vorrichtung nach Anspruch 1, **dadurch gekennzeichnet, dass** die Heftstation (8) umfasst
a) eine Zustelleinheit (12) zum vertikalen Zustellen eines Heftkopfes (13) in Bezug auf den in einem losen Verbund (9) mit der Solarzelle (2.1...2.n) auf dem Transportband (5) durch die Greifeinrichtung (6) gehaltenen Verbinder (3.1...3.n),
b) einen Heftkopf mit mindestens einem Heftstift zum Aufbringen einer Fixierkraft auf den Verbinder beim Aufsetzen des Heftkopfes auf den Verbund durch die Zustelleinheit, wobei für jeden Heftkopf ein vertikales Ausgleichsystem vorgesehen ist, das die Fixierkraft auf den Verbinder durch eine Federkraft aufbringt,
c) eine in den Heftstift (28) eingesetzte Heizpatrone (31) zum Erzeugen einer Hefttemperatur und eine am Heftstift (28) aufgesetzte Heftspitze (30) zum Heften des Verbinders (3.1...3.n) an der Solarzelle (2.1...2.n).

3. Vorrichtung nach Anspruch 1 und 2, **dadurch gekennzeichnet, dass** die Zustelleinheit (12) zum Erzeugen einer schnellen Zustellbewegung des Heftkopfes (13) einen Pneumatikzylinder (15) aufweist, der in einer Schräglage innerhalb der Zustelleinheit (12) um sein der Zylinderstange (15) abgewandtes Ende (17) schwenkbar angeordnet ist, wobei die Zylinderstange (15) des Pneumatikzylinders mit einem Arm (19) eines Winkelhebels (20) zur Verlangsamung am Ende der Zustellbewegung schwenkbar verbunden ist, dessen anderer Arm (21) schwenkbar an einem Träger (22) für den Heftkopf (13) angelenkt ist und der Winkelhebel (20) um eine zu den Armen (19,21) etwa symmetrisch angeordnete Achse (23) drehbar ist.

4. Vorrichtung nach Anspruch 3, **dadurch gekennzeichnet, dass** der Träger (22) für den Heftkopf (13) in zueinander parallel angeordneten Führungen (24) vertikal verschiebbar ist.

5. Vorrichtung nach Anspruch 3, **dadurch gekennzeichnet, dass** die Zustelleinheit (12) zum Erzeugen der Zustellbewegung mit einem elektrischen Antrieb versehen ist.

6. Vorrichtung nach Anspruch 1 und 2, **dadurch gekennzeichnet, dass** der Heftkopf (13) ein Gehäuse (25) aufweist, in dem der Heftstift (28) in einer Führungsbuchse (27) linear geführt angeordnet ist.

7. Vorrichtung nach Anspruch 1, 2 und 6, **dadurch gekennzeichnet, dass** das Ausgleichsystem des Heftstiftes (28) eine in der Führungsbuchse (27) eingesetzte Druckfeder (29) aufweist.

8. Vorrichtung nach Anspruch 1, 2 und 6 **dadurch gekennzeichnet, dass** das Ausgleichsystem mindestens zwei vertikal übereinander angeordnete, den Heftstift haltenden Blattfedern (33) aufweist, die am Gehäuse (25) des Heftkopfes (13) befestigt sind, der durch eine Zustelleinheit (11) in Bezug auf den Verbund (9) vertikal zustellbar ist.

9. Vorrichtung nach Anspruch 1 und 2, **dadurch gekennzeichnet, dass** die Anzahl der an der Zustelleinheit (12) einzeln aufgehängten Heftköpfe (13) der Anzahl der an die Solarzelle zu heftenden Verbinder (3.1...3.n) entspricht.

10. Vorrichtung nach Anspruch 1 und 2, **dadurch gekennzeichnet, dass** die Heftspitze (28) als Verschleißteil austauschbar ist.

11. Vorrichtung nach Anspruch 1 und 2, **dadurch gekennzeichnet, dass** die Heizpatrone (31) mit einem Temperatursensor (32) versehen ist.

12. Vorrichtung nach Anspruch 1 und 2, **dadurch gekennzeichnet, dass** zum mechanischen Verbinden der Zustellstelleinheit (12) mit dem Heftkopf (13) ein Schnellverschluß (14) vorgesehen ist.

13. Verfahren zum Lagefixieren eines Verbinders (Ribbon) aus verzinntem Lötband auf einer Solarzelle beim Transport in einer Fertigungsanlage zur Herstellung von Solarzellenstrings mit einer Vorrichtung nach Anspruch 1, **dadurch gekennzeichnet, dass** die Solarzelle und der Verbinder durch jeweils eine separate Greif- und Ablageeinrichtung in einen zueinander losen Verbund verbindungsgerecht auf einem Transportband nacheinander getaktet platziert und gehalten werden, der Verbinder anschließend in seiner Ablageposition durch Absenken einer von einer Zustelleinheit gehaltenen, unter einer Federkraft stehenden Heftspitze auf der Solarzelle fixiert und mittels Löten aneinander geheftet werden, wobei die für den Verbinder zuständige Greif- und Ablageeinrichtung die zuvor fixierte Ablageposition freigibt, sobald das Heften beginnt oder abgeschlossen ist und erneut einen weiteren Verbinder für die nächstfolgende Solarzelle aufnimmt, diesen positioniert und an der Solarzelle fixiert.

14. Verfahren nach Anspruch 13, **dadurch gekennzeichnet, dass** mehrere Lötverbinder auf der Solarzelle im Takt gleichzeitig geheftet werden.

15. Verfahren nach Anspruch 13, **dadurch gekennzeichnet, dass** für jeden Verbinder eine separate Heftspitze verwendet wird.
